(19) Europäisches Patentamt
European Patent Office
Office européen des brevets

(11) **EP 2 850 659 B1**

(12) **EUROPÄISCHE PATENTSCHRIFT**

(45) Veröffentlichungstag und Bekanntmachung des Hinweises auf die Patenterteilung:
**09.06.2021 Patentblatt 2021/23**

(51) Int Cl.:
*H01L 27/146* (2006.01)    *G01J 5/20* (2006.01)
*G01J 5/00* (2006.01)    *G01J 5/06* (2006.01)

(21) Anmeldenummer: **13718171.5**

(22) Anmeldetag: **19.04.2013**

(86) Internationale Anmeldenummer:
**PCT/EP2013/058134**

(87) Internationale Veröffentlichungsnummer:
**WO 2013/171020 (21.11.2013 Gazette 2013/47)**

(54) **INFRAROT-SENSORVORRICHTUNG**

INFRARED SENSOR DEVICE

DISPOSITIF DE DÉTECTION À INFRAROUGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.05.2012 DE 102012208220**

(43) Veröffentlichungstag der Anmeldung:
**25.03.2015 Patentblatt 2015/13**

(73) Patentinhaber: **Robert Bosch GmbH**
**70442 Stuttgart (DE)**

(72) Erfinder:
• **HERRMANN, Ingo**
**71292 Friolzheim (DE)**
• **SOMMER, Edda**
**70563 Stuttgart (DE)**
• **SCHELLING, Christoph**
**70597 Stuttgart (DE)**
• **RETTIG, Christian**
**72762 Reutlingen (DE)**
• **HATTASS, Mirko**
**70191 Stuttgart (DE)**

(56) Entgegenhaltungen:
**EP-A2- 1 246 251**    **WO-A1-2005/098380**
**US-A1- 2001 028 035**    **US-A1- 2002 195 563**
**US-A1- 2003 057 372**

EP 2 850 659 B1

## Beschreibung

Die Erfindung betrifft eine Infrarot-Sensorvorrichtung .

Stand der Technik

Im Stand der Technik sind oberflächenmikromechanisch hergestellte Pixelstrukturen bekannt. Beispielsweise offenbart die WO 9325877 in Passivierschichten aus $SiO_2$ oder $Si_xN_x$ eingebettete dünne Metallleitungen mit einem ebenfalls in Passivierschichten eingebetteten Bolometerschichtwiderstand, welche in einer Anordnung verbunden sind, die zusammen mit einer Reflexionsschicht in geeignetem Abstand einen $\lambda/4$-Absorber bildet.

Aus der WO 2007147663 ist die bulkmikromechanische Herstellung von thermisch isolierenden Kavernen bekannt, über denen durch Strukturierung der Si- oder SOI-Membran an möglichst langen und dünnen Armen aufgehängte Sensorelemente erzeugt werden.

US 2003/057372 A1 beschreibt eine Halbleiter-Bildgebungsvorrichtung mit einer matrixartigen Anordnung von Infrarotsensor-Pixeln auf einem Halbleitersubstrat mit Zeilen- und Spaltenleitungen.

EP 1 246 251 A2 beschreibt eine Infrarotsensoreinrichtung und ein zugehöriges Herstellungsverfahren.

US 2001/028035 A1 und US 2002/195563 A1 beschreiben jeweils einen Infrarotsensor und ein zugehöriges Herstellungsverfahren mit Halbleiterdioden als Sensorelemente, welche über Aufhängeeinrichtungen an einem Substrat aufgehängt sind und über Zeilen- und Spaltenleitungen adressiert werden.

WO 2005/0983830 A1 beschreibt durch Halbleiterdioden ausgebildete Infrarot-Sensorelemente, welche mit einer Absorberschicht bedeckt sind.

Ferner ist ein IR-Sensorarray basierend auf einer SOI-Pixeltechnologie mit Rundumpassivierung bekannt. Die Aufhängeärmchen sind bei diesem IR-Sensorarray zwischen Pixel und Spalten- bzw. Zeilenverdrahtung angeordnet, wobei sich der pn-Übergang bis zur Oberfläche erstreckt.

Offenbarung der Erfindung

Es ist eine Aufgabe der Erfindung, eine verbesserte Infrarot-Sensorvorrichtung bereitzustellen.

Die Aufgabe wird gelöst mit einer Infrarot-Sensorvorrichtung mit den Merkmalen des Patentanspruchs 1.

Die vorliegende Erfindung schafft gemäß einem weiteren Aspekt ein Infrarot-Sensorfeld mit mehreren erfindungsgemäßen Infrarot-Sensorvorrichtungen.

Außerdem wird ein Verfahren zur Herstellung einer Infrarot-Sensorvorrichtung bereitgestellt, welches nicht Teil der beanspruchten Erfindung ist, und welches folgende Schritte aufweist:

- Bereitstellen eines Halbleitersubstrats;
- Erzeugen einer oberflächenmikromechanischen Membran mit Ankerstrukturen;
- Einbringen von Dotierungen in die Membran;
- Aufbringen von wenigstens zwei Lagen Absorbermaterial aus z. B. Siliziumoxid bevorzugt mit einer optischen Gesamtdicke eines ungeradzahligen Viertels einer Wellenlänge einer zu detektierenden Strahlung;
- Aufbringen und Strukturieren von wenigstens zwei Leiterbahnen für eine Zeilen- und Spaltenverdrahtung;
- Strukturieren einer Aufhängeeinrichtung und Einbringen von Opferschichtätzlöchern durch das Oxidmaterial; und
- Zeitgesteuertes, vorzugsweise isotropes Opferschichtätzen der Membran wenigstens bis zur Entfernung des Halbleitersubstrats unter der Aufhängeeinrichtung.

Vorteile der Erfindung

Mittels der Kavernen wird in der erfindungsgemäßen Infrarot-Sensorvorrichtung vorteilhaft eine thermische Isolierung bzw. Entkopplung des Sensorelements und des Kalibrierungselements vom übrigen Halbleitersubstrat bereitgestellt. Dadurch kann vorteilhaft ein hochsensitives Pixel realisiert werden, mit dem eine zu detektierende thermische Strahlung präzise erfasst werden kann. Mittels des Kalibrierungselements kann in vorteilhafter Weise eine Kalibrierung des Sensorelements in Form einer Eliminierung einer Substrattemperatur durchgeführt werden. Vorteilhaft können bei einer Verwendung der erfindungsgemäßen Infrarot-Sensorvorrichtung in einer Thermographie-Kamera eine Pixeldichte und eine Bildwiederholfrequenz erhöht sein. Die Kavernen können vorteilhaft kostengünstig mittels eines APSM-Prozesses (engl. advanced porous silicon membrane) erzeugt werden.

Bevorzugte Weiterbildungen der Infrarot-Sensorvorrichtung sind Gegenstand von Unteransprüchen.

Eine bevorzugte Ausführungsform der Infrarot-Sensorvorrichtung sieht vor, dass das Halbleitersubstrat ein einkristallines Silizium-Substrat ist, in welchem für das Sensorelement und für das Kalibrierungselement jeweils wenigstens eine Diode ausgebildet ist. Die Dioden im Sensorelement und im Kalibrierungselement stellen gut bekannte Halbleiterbauelemente dar, bei denen eine Temperaturerhöhung zu einem dazu proportionalen Spannungsabfall führt. Dadurch wird vorteilhaft ein Sensierelement bereitgestellt, welches eine ihren Wert temperaturabhängig ändernde Eigenschaft aufweist. Durch die Verwendung eines einkristallinen Siliziums als Halbleitersubstrat kann vorteilhaft ein temperaturabhängig ausgeprägter Spannungsabfall an den Dioden generiert werden. Ferner kann durch die Verwendung von einkristallinem Halbleitersubstrat im Vergleich zu polykristallinem Halbleitermaterial ein deutlich verbessertes Rauschverhalten erzielt werden. Für die Erfindung wird somit eine durch Infrarotstrahlung bewirkte Temperaturänderung ausgenützt, um einen dadurch generierten elektrischen Spannungsabfall an der Diode auszuwerten.

Eine vorteilhafte Weiterbildung der Infrarot-Sensorvorrichtung sieht vor, dass das Sensorelement mittels einer Aufhängeeinrichtung in zwei Bereichen am Halbleitersubstrat befestigt ist. Dadurch erhält man vorteilhaft eine geringe thermische Kopplung an das Substrat, wodurch eine Sensiergenauigkeit für das Sensorelement erhöht ist.

Eine vorteilhafte Weiterbildung der Infrarot-Sensorvorrichtung sieht vor, dass die Aufhängeeinrichtung in vertikaler Richtung im Wesentlichen symmetrisch ausgebildet ist, wobei eine elektrische Leiterbahn in der Aufhängeeinrichtung im Wesentlichen mittig zwischen zwei im Wesentlichen gleich dicken Schichten des Oxidmaterials angeordnet ist, wobei die Leiterbahn lateral von Absorbermaterial, beispielsweise ein Oxid, insbesondere ein Siliziumoxid, bedeckt ist. Vorteilhaft resultiert daraus ein stresssymmetrischer Aufbau der Aufhängestruktur, wodurch eine ausgleichende Verformung von einzelnen Elementen der Aufhängeeinrichtung unterstützt ist. Die Bedeckung mittels der Oxidschicht stellt für die Leiterbahnen eine elektrische Isolierung und einen mechanischen Schutz dar. Idealerweise ist ein Sensorelement thermisch völlig vom Halbleitersubstrat isoliert und für Infrarotstrahlung hochabsorbierend ausgelegt, während ein Kalibrierelement thermisch mit dem Halbleitersubstrat kurzgeschlossen und für Infrarotstrahlung völlig transparent sein sollte. Eine bevorzugte Ausführungsform der erfindungsgemäßen Infrarot-Sensorvorrichtung zeichnet sich daher dadurch aus, dass das Oxidmaterial im Bereich der Aufhängeeinrichtung des Sensorelements und im Bereich der Dioden des Kalibrierungselements eine geringere Schichtdicke als an der übrigen Infrarot-Sensorvorrichtung aufweist. Dadurch kann für das Sensorelement vorteilhaft eine geringe Wärmekopplung mit dem Halbleiter-Substrat bereitgestellt werden. Für das Kalibrierungselement wird auf diese Weise vorteilhaft eine geringe Strahlungssensitivität für die einfallende Strahlung und damit eine gute Kalibrierungswirkung bereitgestellt.

Die erfindungsgemäße Infrarot-Sensorvorrichtung sieht vor, dass das Sensorelement mit dem Halbleitersubstrat thermisch gut entkoppelt ist. Beispielsweise kann die genannte gute thermische Entkopplung mittels langer Aufhängungseinrichtungen mit einem geringen Querschnitt und bestehend aus Absorber- (z. B. Siliziumoxid) und Leiterbahnmaterialien (z. B. Ti, TiN, Ta, TaN) mit einem geringen Wärmeleitwert realisiert werden, wodurch eine Diodentemperatur infolge eine Strahlungsabsorption als Sensorgröße für das Sensorelement sehr genau erfasst werden kann.

Die erfindungsgemäße Infrarot-Sensorvorrichtung sieht vor, dass das Kalibrierungselement mit dem Halbleitersubstrat thermisch gekoppelt ist. Insbesondere wird die genannte gute thermische Kopplung mittels direkter zwischen Spalten- bzw. Zeilenzuleitung und Diodenbereich verlaufender Wärmebrücken, die eine thermisch gut leitfähige Metallisierung aus z. B. Material der Spalten- bzw. Zeilenleitung umfassen können, vom Kalibrierungselement zum Substrat realisiert , wodurch eine Substrattemperatur als Kalibriergröße für das Sensorelement sehr genau erfasst werden kann. Eine vorteilhafte Weiterbildung der Infrarot-Sensorvorrichtung sieht vor, dass eine optische Dicke des auf dem Sensorelement angeordneten Oxidmaterials im Wesentlichen einem ungeradzahligen Viertel einer Wellenlänge einer zu detektierenden Strahlung entspricht. Dies stellt eine günstige Dimensionierung der Oxidschicht für eine Absorption der zu detektierenden thermischen Strahlung dar.

Eine bevorzugte Ausführungsform der Infrarot-Sensorvorrichtung weist auf einer Oberfläche des Sensorelements auf dem Oxidmaterial eine Reflektorschicht auf. Vorteilhaft wird mittels der Reflektorschicht ein Absorptionsweg der zu detektierenden Strahlung verlängert und dadurch ein Absorptionsgrad vergrößert.

Eine vorteilhafte Weiterbildung der Infrarot-Sensorvorrichtung zeichnet sich dadurch aus, dass ein Material der elektrischen Leiterbahn wenigstens eines aus der Gruppe: Ti, TiN, Ta, TaN und/oder eine Kombination dieser Materialien ist. Mit diesen Materialien bzw. Kombinationen daraus werden günstige Kompromisse zwischen elektrischer Leitfähigkeit und Wärmeleitung eingegangen, wodurch das Sensorelement bei guten elektrischen Eigenschaften vorteilhaft nur geringfügig thermisch an das Substrat gekoppelt ist.

Eine vorteilhafte Weiterbildung der Infrarot-Sensorvorrichtung zeichnet sich dadurch aus, dass im Wesentlichen unterhalb des Sensorelements am Boden der Kaverne eine Bündelungseinrichtung zum Bündeln der mittels des Sensorelements zu detektierenden Strahlung ausgebildet ist. Mittels der Bündelungseinrichtung kann die Strahlung effizienter erfasst werden, wodurch sich für das Sensorelement vorteilhaft ein erhöhtes Signal-zu-Rausch-Verhältnis ergibt.

Eine vorteilhafte Weiterbildung der Infrarot-Sensorvorrichtung sieht vor, dass das Absorbermaterial aus z. B. Siliziumoxid auf wenigstens einem Abschnitt einer Oberfläche des Sensorelements und des Kalibrierungselements noppenartig ausgebildet ist. Mit dieser Maßnahme wird vorteilhaft ein Ankleben des Sensor- und des Kalibrierungselements an einer darüberliegenden anwendungsspezifischen integrierten Schaltung (ASIC) verhindert, falls es dort anschlagen sollte. Vorteilhaft resultiert daraus eine erhöhte Betriebssicherheit für die Infrarot-Sensorvorrichtung.

Weitere Merkmale und Vorteile der vorliegenden Erfindung werden nachfolgend anhand von Ausführungsformen mit Bezug auf die Figuren erläutert. Dabei bilden alle beschriebenen oder dargestellten Merkmale für sich oder in beliebiger Kombination den Gegenstand der Erfindung, unabhängig von ihrer Zusammenfassung in den Patentansprüchen oder deren Rückbeziehung, sowie unabhängig von ihrer Formulierung bzw. Darstellung in der Beschreibung bzw. in den Figuren. Die Figuren sind vor allem dazu gedacht, die erfindungswesentlichen Prinzipien zu verdeutlichen und sind nicht notwendigerweise maßstabsgetreu bzw. geometrisch exakt dargestellt. In den Figuren bezeichnen gleiche Bezugszeichen gleiche bzw. funktionsgleiche Elemente.

Kurze Beschreibung der Figuren

Es zeigen:

| | |
|---|---|
| Fig. 1 | eine Querschnittsansicht einer Ausführungsform der erfindungsgemäßen Infrarot-Sensorvorrichtung; |
| Fig. 2 | eine Draufsicht auf eine Ausführungsform der erfindungsgemäßen Infrarot-Sensorvorrichtung; |
| Fig. 3a bis Fig. 3d | Verfahrensabschnitte eines Verfahrens zur Herstellung einer Ausführungsform der erfindungsgemäßen Infrarot-Sensorvorrichtung mit entsprechenden Zwischenprodukten; |
| Fig. 4 | eine Querschnittsansicht einer weiteren Ausführungsform der erfindungsgemäßen Infrarot-Sensorvorrichtung; und |
| Fig. 5 | eine Querschnittsansicht einer weiteren Ausführungsform der erfindungsgemäßen Infrarot-Sensorvorrichtung. |

Ausführungsformen der Erfindung

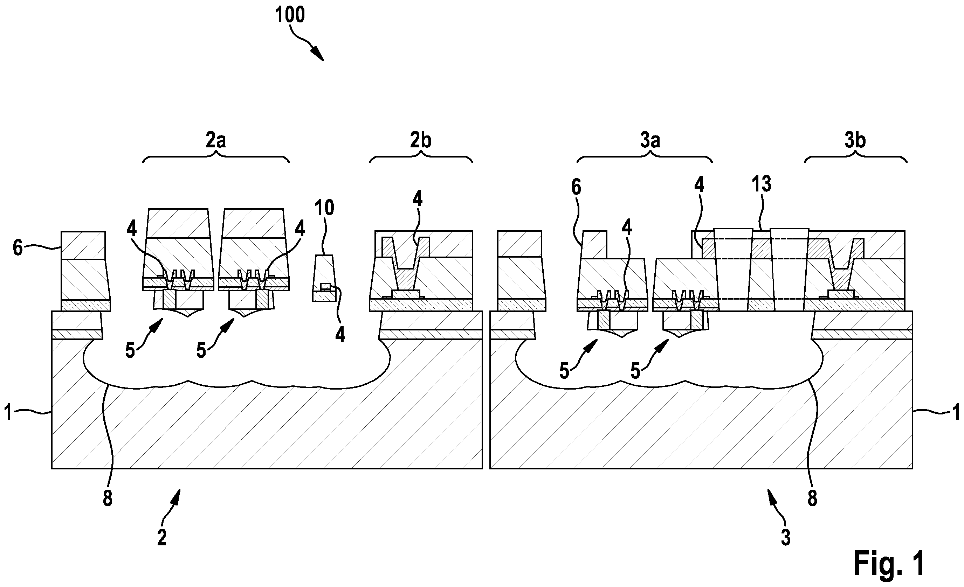

Fig. 1 zeigt eine prinzipielle Querschnittsansicht einer Ausführungsform der erfindungsgemäßen Infrarot-Sensorvorrichtung 100. Ein Grundmaterial der Infrarot-Sensorvorrichtung 100 umfasst ein Halbleitersubstrat 1, welches vorzugsweise als einkristallines Silizium-Substrat ausgebildet ist, welches gegenüber polykristallinem Silizium vorteilhaft ein deutlich günstigeres Rauschverhalten (z.B. kein Korngrenzenrauschen) aufweist. Auf einer Oberfläche des Halbleiter-Substrats 1 sind mehrere Schichten von Oxidmaterial 6 aufgebracht, die als ein Absorptionsvolumen für eine zu detektierende thermische Strahlung (insbesondere eine Infrarotstrahlung) in einem Pixelbereich 2a dienen. Die Oxidschichten weisen eine Metallisierungsebene mit Leiterbahnen 4 zur elektrischen Versorgung eines Sensorelements 2 auf. Eine Oberfläche der Infrarot-Sensorvorrichtung 100 ist vorzugsweise mit einem thermisch aufgewachsenen Oxidmaterial 6 passiviert. Dies stellt eine Schutzschicht für die Oberfläche dar und erzeugt vorteilhaft wenige Oberflächendefekte.

Das Sensorelement 2 weist wenigstens eine Halbleiterdiode auf, wobei als Grundmaterial der Diode 5 das genannte einkristalline Silizium-Substrat verwendet wird. Das Sensorelement 2 ist innerhalb des Halbleiter-Substrats 1 durch eine Kaverne 8, die im Wesentlichen unterhalb des Sensorelements 2 ausgebildet ist, vom restlichen Substrat thermisch isoliert.

Eine Aufhängeeinrichtung 10 für das Sensorelement 2 wird durch wenigstens zwei rundum freigestellte Schichten von Oxidmaterial 6 gebildet, wobei zwischen den Schichten eine Leiterbahn 4 zur elektrischen Versorgung des Sensorelements 2 angeordnet ist. Man erkennt, dass die Dioden 5 im Wesentlichen unterhalb der Leiterbahnen 4 angeordnet sind, was vorteilhaft kurze elektrische Leitungswege zur Ansteuerung der Dioden 5 darstellt. In vertikaler Ausrichtung ist die Aufhängeeinrichtung 10 im Wesentlichen symmetrisch aufgebaut, wobei eine Gesamtdicke des Oxidmaterials 6 im Bereich der Aufhängeeinrichtung 10 kleiner ist als im Pixelbereich 2a des Sensorelements 2. Dadurch kann eine Wärmekopplung der Aufhängeeinrichtung 10 aufgrund einer geringen Querschnittsfläche vorteilhaft niedrig gehalten werden. Durch den symmetrischen Aufbau der Aufhängeeinrichtung 10 ist zudem eine verringerte Grundauslenkung nach einem Freiätzen der Aufhängeeinrichtung 10 unterstützt, weil sich mechanische Verspannungszustände der einzelnen Oxidschichten gegenseitig kompensieren können. Im Ergebnis lässt sich dadurch zusammen mit einer erhöhten Absorberschichtdicke mit Oxidmaterial 6 im Pixelbereich 2a ein verbessertes Signal-zu-Rausch-Verhältnis (SNR) der Infrarot-Sensorvorrichtung 100 erreichen. Vorteilhaft kann dadurch eine hochsensitive Infrarot-Sensorvorrichtung 100 bereitgestellt werden.

Eine Leiterbahn 4 umfasst vorzugsweise eine Einzellage oder Mehrlagen einer Kombination der folgenden Materialien: Ti, TiN, Ta, TaN. Diese Materialien stellen allesamt vorteilhaft einen günstigen Kompromiss zwischen elektrischer Leitfähigkeit und Wärmeleitung dar, so dass durch deren Verwendung eine starke thermische Kopplung des Sensorelements 2 an das Halbleitersubstrat 1 vermieden wird. Eine Leiterbahn 4 weist vorzugsweise einen Querschnitt von weniger als ungefähr $0,1\ \mu m^2$ auf.

Eine optische Gesamtdicke der Oxidschichten auf dem Sensorelement 2 entspricht im Wesentlichen einem ungeradzahligen Vielfachen eines Viertels der Wellenlänge $\lambda$ der zu detektierenden Strahlung, was für die Absorption als besonders günstig bekannt ist. Zwischen einer Oberfläche des Sensorelements 2 und einer gegenüberliegenden ASIC-Oberfläche (nicht dargestellt) kann vorteilhaft ein Abstand von einem Viertel der zu detektierenden Wellenlänge durch einen äußeren Bondrahmen (nicht dargestellt) eingestellt werden.

Ein Kalibrierungselement 3, welches als ein Referenzelement für das Sensorelement 2 der Infrarot-Sensorvorrichtung 100 angesehen werden kann, ist zum Sensorelement 2 im Prinzip identisch aufgebaut mit dem Unterschied, dass das Kalibrierungselement 3 eine gute thermische Kopplung an das Halbleiter-Substrat 1 aufweist. Diese wird durch direkt auf dem kürzesten Wege zwischen Spalten- bzw. Zeilenleitungsbereich 20 und Diodenbereichen 5 verlaufenden Wärmebrücken 13, die außerdem gut thermisch leitfähige Metallstrukturen 4 aus z. B. Spalten- bzw. Zeilenmetallisierung enthalten können, bereitgestellt , die eine Aufhängestruktur mit einem großen Querschnitt für das Kalibrierungselement 3 darstellen.

Eine verringerte Sensitivität des Kalibrierungselements 3 für thermische Strahlung ("thermische Blindheit") wird durch eine verringerte Dicke des Oxidmaterials 6 in einem Pixelbereich 3a des Kalibrierungselements 3 erreicht. Mittels des Kalibrierungselements 3 kann eine Hintergrund-Substrattemperatur des Halbleitersubstrats 1 erfasst werden, wodurch berücksichtigt wird, dass auch das Substrat selbst als ein thermischer Strahler wirkt. Durch eine Differenzbildung von Sensorsignalen des Sensorelements 2 und des Kalibrierungselements 3 kann auf diese Weise der Einfluss der Halbleitersubstrattemperatur weitgehend eliminiert werden durch eine Art Kalibrierung bzw. Offsetkorrektur des Sensorelements 2 mit dem Kalibrierungselement 3. Im Ergebnis kann dadurch ein möglichst großes Nutzsignal des Sensorelements 2 generiert werden.

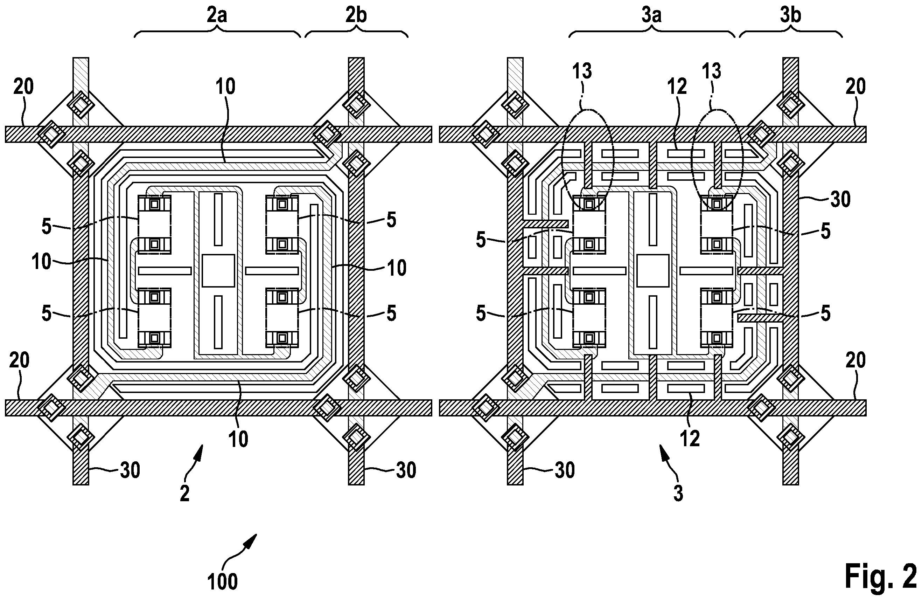

Fig. 2 zeigt eine schematische Draufsicht auf eine Ausführungsform einer erfindungsgemäßen Infrarot-Sensorvorrichtung 100. Das Sensorelement 2 und das Kalibrierungselement 3 weisen beispielhaft jeweils insgesamt vier Dioden 5 auf, wobei eine Mindestanzahl der Dioden 5 für das Sensorelement 2 und für das Kalibrierungselement 3 eins beträgt. Die Dioden 5 sind innerhalb der genannten Elemente 2, 3 elektrisch in Reihe und/oder parallel geschaltet.

Eine Verankerung (nicht dargestellt) der Aufhängeeinrichtung 10 am Halbleitersubstrat 1 wird an Angriffspunkten von geeigneten Ankerstrukturen 2b vorgenommen. Beispiele für derartige Strukturen sind Stützsäulen und/oder -wände (nicht dargestellt) zwischen den einzelnen Pixelbereichen 2a der Sensorelemente 2, wobei die Stützsäulen bzw. -wände aus Halbleitersubstratmaterial gebildet sind.

In Fig. 2 sind beispielhaft zwei Zeilenleitungen 20 und zwei sich über/unterkreuzende Spaltenleitungen 30 erkennbar, die elektrische Versorgungs- bzw. Adressierungseinrichtungen (nicht dargestellt) von Sensorelementen 2 und Kalibrierungselementen 3 in einem Sensorfeld repräsentieren. Vorzugsweise ist dabei pro Feld von Sensorelementen 2 eine Reihe von Kalibrierungselementen 3 vorgesehen. Auf diese Art und Weise erhält jede Zeile bzw. Spalte eines Arrays wenigstens ein Kalibrierungselement 3.

Bei der Draufsicht auf das Kalibrierungselement 3 ist erkennbar, dass die Wärmebrücken einen Aufhängungsbereich des Kalibrierungselements 3 am Halbleitersubstrat 1 repräsentieren. Zwischen den Wärmebrücken 13 sind Opferschichtätzlöcher 12 erkennbar, die zu einem Unterätzen der Aufhängungseinrichtung verwendet werden. Verglichen mit der Aufhängeeinrichtung 10 des Sensorelements 2 ist der Aufhängungsbereich des Kalibrierungselements 3 massiver und als kurze, direkte thermisch gut leitfähige Verbindung zwischen Spalten- bzw. Zeilenleitungsbereich und Diodenbereich 5 ausgebildet, wodurch eine stärkere Wärmekopplung des Halbleitersubstrats 1 an das Kalibrierungselement 3 realisiert ist.

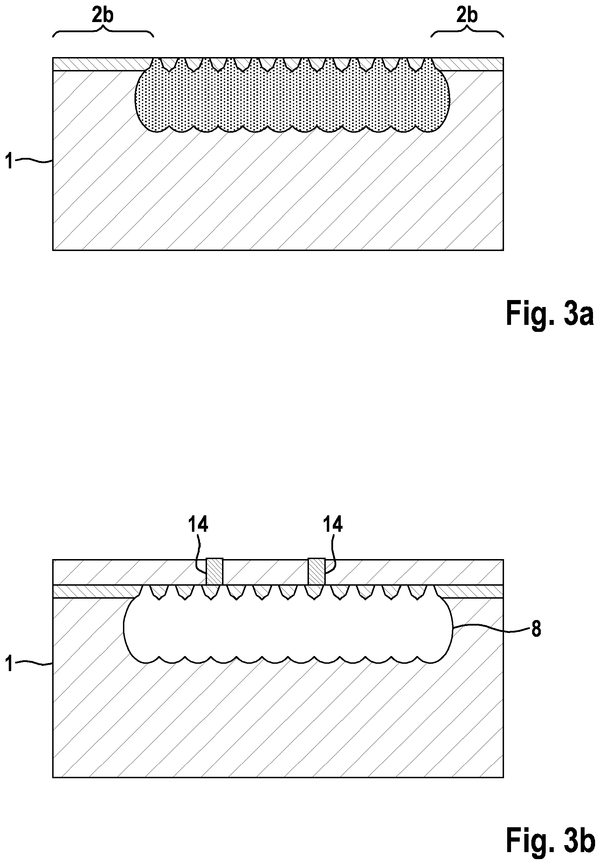

Fig. 3a zeigt ein Zwischenprodukt eines ersten Schritts eines Verfahrens zur Herstellung eines Sensorelements 2 der erfindungsgemäßen Infrarot-Sensorvorrichtung 100. Es wird dabei ein Halbleitersubstrat 1 bereitgestellt, welches vorzugsweise als ein monokristallines Silizium ausgebildet ist. Mittels eines dotierungsselektiven Ätzvorgangs durch eine gitterförmige Ätzmaske wird eine oberflächenmikromechanische Membran mit Ankerstrukturen 2b erzeugt. Dabei wird Substratmaterial porösgeätzt, welches nicht n-Typ dotiert ist. Im Anschluss daran wird das poröse Silizium umgelagert bzw. selektiv entfernt, wodurch ein Hohlraum in Form einer Kaverne 8 entsteht.

Fig. 3b zeigt ein Zwischenprodukt eines folgenden Epitaxierungs-Schritts, bei dem auf die Struktur von Fig. 3a ein zusätzliches Halbleitersubstratmaterial 1 aufgewachsen wird, wodurch eine geschlossene Membran erhalten wird. In das aufgewachsene Halbleitersubstratmaterial 1 werden daraufhin Dotierungen 14 zum Ausbilden der Dioden 5 eingebracht. Die Kaverne 8 ist unterhalb der epitaktisch aufgebrachten Substratschicht angeordnet.

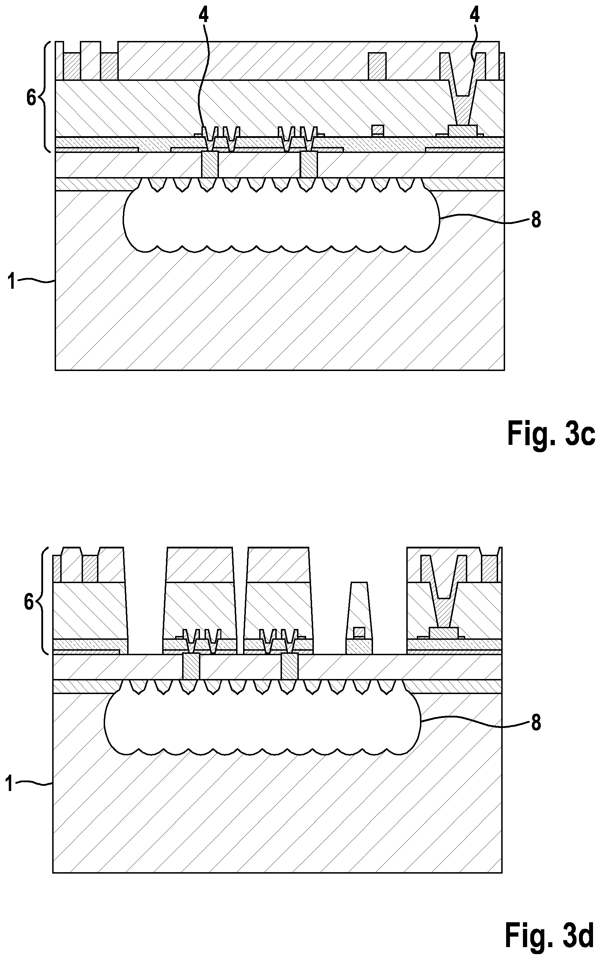

Fig. 3c zeigt ein Zwischenprodukt eines darauffolgenden Herstellungsschritts, bei dem wenigstens zwei Lagen von Oxidmaterial 6 mit einer optischen Gesamtdicke von einem ungeradzahligen Viertel der zu detektierenden Wellenlänge aufgebracht wird. Es wird zudem ein Aufbringen und ein Strukturieren von wenigstens zwei Leiterbahnlagen für Leiterbahnen 4 einer Spalten- und Zeilenverdrahtung eines Sensorfelds durchgeführt. Dabei wird innerhalb der Schichten eine Verdrahtungsebene für die Leiterbahnen 4 abgeschieden und strukturiert. Auf diese Weise werden Leiterbahnen 4 erhalten, welche vorzugsweise unterschiedliche Materialien aufweisen können. Diese umfassen eines oder mehrere der Materialien: Ti, TiN, Ta, TaN oder eine Kombination dieser Materialien.

Fig. 3d zeigt prinzipiell ein Strukturieren der Aufhängeeinrichtung 10 und ein Einbringen von Opferschichtätzlöchern durch die mehrlagige Oxidschicht. In einem darauffolgenden optionalen Schritt kann ein Teil der Oxidschichtdicke mittels eines Leiterbahnopferschichtprozesses im Bereich der Aufhängeeinrichtung 10 (für das Sensorelement 2) sowie im Pixelbereich 3a (für das Kalibrierungselement 3) entfernt werden. Dadurch ist die Oxidschicht im Bereich der genannten Strukturen dünner ausgebildet.

Als Ergebnis des Opferschichtätzens wird ein räumlich im Wesentlichen freigestelltes Sensorelement 2 bzw.

Kalibrierungselement 3 erhalten, welches durch eine unterhalb des Sensorelements 2 bzw. des Kalibrierungselements 3 angeordnete Kaverne 8 vom umliegenden Halbleitersubstrat 1 thermisch isoliert ist. Ferner wird ein Unterätzen der Schichten von Oxidmaterial 6 durchgeführt, um dadurch die Aufhängeeinrichtung 10 für das Sensorelement 2 zu bilden bzw. freizulegen.

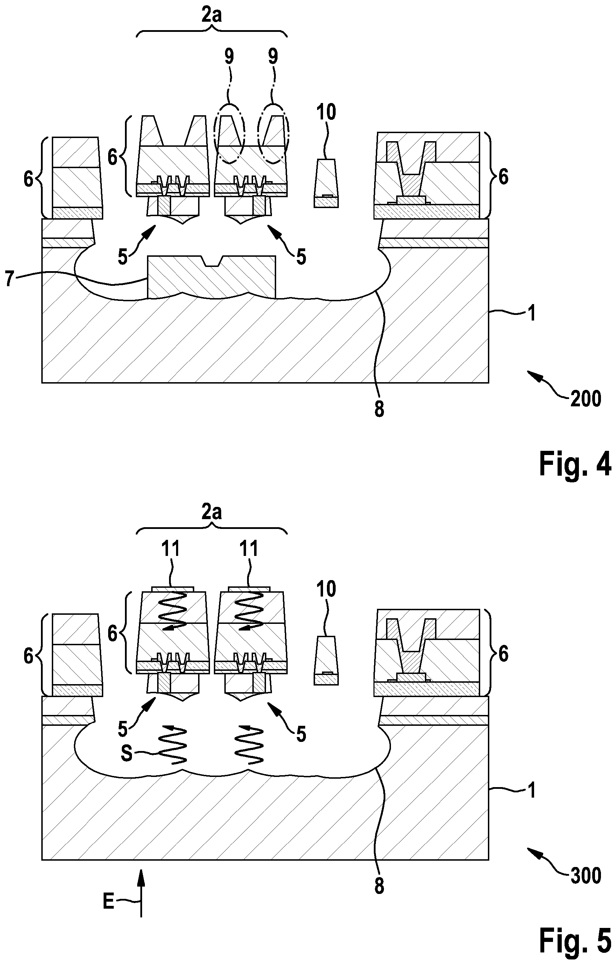

In einem nächsten Herstellungsschritt (z. B. Fig. 1 links) wird ein zeitgesteuertes, in einem ersten Schritt bevorzugt weitgehend isotropes Opferschichtätzen des Halbleitersubstratmaterials der Membran wenigstens bis zur Entfernung des Siliziums unter den Aufhängestrukturen durchgeführt. In einem zweiten, optionalen Schritt wird ein anisotropes, vor allem in die Tiefe gerichtetes Opferschichtätzen zur Erzeugung einer Mesastruktur unterhalb des Pixelbereichs 2a im Kavernenboden durchgeführt. Mit der Mesastruktur (es. la mesa) wird eine tischartige Bündelungseinrichtung 7 (siehe Fig. 4) bereitgestellt, welche als ein Lichtwellenleiter wirkt und vorteilhaft zu einem Bündeln der einfallenden Strahlung S auf die Dioden 5 des Sensorelements 2 verwendet wird. Im Ergebnis trifft dadurch weniger diffuse und mehr gerichtete Strahlung auf das Sensorelement 2.

Fig. 4 zeigt im Querschnitt eine mögliche weitere Ausführungsform der erfindungsgemäßen Infrarot-Sensorvorrichtung 200. Dabei können die Schichten von Oxidmaterial 6 im Pixelbereich 2a noppenartige Erhebungen 9 aufweisen, die ein Ankleben des Sensorelements 2 an einer darüberliegenden, in einem späteren Herstellungsschritt zu montierenden anwendungsspezifischen integrierten Schaltung (ASIC) (nicht dargestellt) verhindern. Durch die minimierten Kontaktflächen wird nach einem Anschlagen des Pixels an die gegenüberliegende ASIC-Oberfläche eine Wahrscheinlichkeit eines Anklebens stark verringert.

In Fig. 4 ist auch die dem Boden der Kaverne 8 als Folge des obengenannten optionalen Ätzschritts erzeugte Bündelungseinrichtung 7 erkennbar, welche die zu detektierende Strahlung S auf das Sensorelement 2 fokussiert. Dadurch kann der Wirkungsgrad des Sensorelements 2 bedeutend verbessert werden, indem ein Signal/Rauschabstand erhöht ist. Selbstverständlich kann die Infrarot-Sensorvorrichtung 200 die genannten Erhebungen 9 bzw. die Bündelungseinrichtung 7 in Kombination oder auch jeweils einzeln aufweisen.

Fig. 5 zeigt in einer Querschnittsansicht einer weiteren möglichen Ausführungsform der erfindungsgemäßen Infrarot-Sensorvorrichtung 300, in der auf einer Oberfläche des Oxidmaterials 6 im Pixelbereich 2a eine Reflektorschicht 11 (beispielsweise aus Metall) angeordnet ist. Als Effekt der Reflektorschicht 11 kann ein Absorptionsweg der zu detektierenden Strahlung S, die vorzugsweise eine Einfallsrichtung E durch eine Rückseite eines Wafers aufweist, verlängert werden. Der von der Strahlung S durchlaufene Weg wird durch das absorbierende Oxidmaterial 6 im Wesentlichen verdoppelt, wodurch die absorbierte Leistung gemäß dem Lambert-Beerschen Gesetz:

$$I(x) = I_0 * e^{-\lambda x}$$

mehr als verdoppelt wird. Dadurch kann die Absorption der thermischen Strahlung S innerhalb des Sensorelements 2 und dadurch der Wirkungsgrad des Sensorelements 2 vorteilhaft erhöht sein.

Zusammenfassend wird mit der Erfindung eine verbesserte Infrarot-Sensorvorrichtung geschaffen, die sich für eine Verwendung in einem Sensorarray, z.B. für einen Einsatz in Thermographie-Kameras eignet. Die Erfindung kann in allen Anwendungen eingesetzt werden, in denen thermische Strahlung räumlich aufgelöst detektiert werden soll und bei denen Stückkosten eine größere Rolle spielen als eine hochpräzise Temperaturmessung. Beispiele hierfür sind KfZ-Nachtsichtvorrichtungen und die Thermographie für die Gebäudedämmung oder die Prozessüberwachung. Ferner können mit der Erfindung Thermographiekameras für den Hausgebrauch (z.B. zur Lokalisierung von Isolations- bzw. Wärmelecks) realisiert werden. Zudem kann die erfindungsgemäße Infrarot-Sensorvorrichtung als ein Einzelpixel zur Temperaturüberwachung unter Erfassung von thermischer Eigenstrahlung verschiedener Gegenstände, Einrichtungen oder Lebewesen verwendet werden.

Vorteilhaft weist ein mit der erfindungsgemäßen Infrarot-Sensorvorrichtung realisiertes Bildpixelelement eine geringe thermische Kopplung an das Substrat durch einen geringen Querschnitt der Aufhängeeinrichtung, durch fehlende Wärmebrücken und durch eine dicke Absorberschicht und/oder Reflektorschicht auf. Vorteilhaft kann ein in der erfindungsgemäßen Infrarot-Sensorvorrichtung realisiertes Kalibrierungselement ein Sensierverhalten des Sensorelements bedeutend verbessern, indem ein verzerrender Einfluss einer Substrattemperatur weitestgehend eliminiert wird.

Im Ergebnis kann mit der Erfindung eine Infrarot-Sensorvorrichtung mit hochsensitiven Bildpixeln, niedriger Wärmekapazität, geringer Wärmekopplung an das Substrat und damit hoher Bildwiederholfrequenz realisiert werden. Gegenüber herkömmlichen Infrarot-Sensorvorrichtungen lässt sich die erfindungsgemäße Infrarot-Sensorvorrichtung bei gleichem Signal-zu-Rauschverhältnis kleiner und damit kostengünstiger herstellen.

Obwohl die vorliegende Erfindung anhand bevorzugter Ausführungsbeispiele beschrieben wurde, ist sie nicht darauf beschränkt. Insbesondere sind die genannten Materialien und Topologien nur beispielhaft und nicht auf die erläuterten Beispiele beschränkt. Der Fachmann wird also die beschriebenen Merkmale der Erfindung abändern oder miteinander kombinieren können, ohne vom Kern der Erfindung abzuweichen.

**Patentansprüche**

1. Infrarot-Sensorvorrichtung (100;200;300), aufweisend:

   - ein Halbleitersubstrat (1);
   - eine Vielzahl von Zeilenleitungen (20) und eine Vielzahl von Spaltenleitungen (30);
   - wenigstens ein mikromechanisch ausgebildetes Sensorelement (2), welches mittels einer Aufhängeeinrichtung (10) des Sensorelements (2) mit dem Halbleitersubstrat (1) verbunden ist, wobei die Aufhängeeinrichtung (10) des Sensorelements (2) Leiterbahnen (4) zur elektrischen Versorgung des Sensorelements (2) aufweist, welche mit zumindest einer der Vielzahl von Zeilenleitungen (20) und/oder der Vielzahl von Spaltenleitungen (30) elektrisch verbunden sind; und
   - wenigstens ein mikromechanisch ausgebildetes Kalibrierungselement (3) für das Sensorelement (2), welches mittels einer Aufhängeeinrichtung des Kalibrierungselements (3) mit dem Halbleitersubstrat (1) verbunden ist, wobei die Aufhängeeinrichtung des Kalibrierungselements (3) Leiterbahnen (4) zur elektrischen Versorgung des Kalibrierungselements (3) aufweist, welche mit zumindest einer der Vielzahl von Zeilenleitungen (20) und/oder der Vielzahl von Spaltenleitungen (30) elektrisch verbunden sind;

   wobei für das Sensorelement (2) und für das Kalibrierungselement (3) jeweils wenigstens eine entsprechend zu dem Sensorelement (2) und dem Kalibrierungselement (3) zugehörige Diode (5) ausgebildet ist,
   wobei zumindest auf den Dioden (5) des Sensorelements (2) und des Kalibrierungselements (3) ein Absorbermaterial (6) angeordnet ist;
   wobei im Halbleitersubstrat (1) im Wesentlichen unterhalb des Sensorelements (2) und im Wesentlichen unterhalb des Kalibrierungselements (3) jeweils eine Kaverne (8) ausgebildet ist, wobei mittels der Kavernen (8) das Sensorelement (2) und das Kalibrierungselement (3) vom übrigen Halbleitersubstrat (1) getrennt sind;
   wobei das Kalibrierungselement (3) mit dem Halbleitersubstrat (1) thermisch durch Wärmebrücken (13) direkt auf dem kürzesten Wege zwischen einem Spalten- bzw. Zeilenleitungsbereich (20, 30) und einem Bereich mit der mindestens einen Diode (5) gekoppelt ist; und
   wobei die Wärmebrücken (13) eine Metallstruktur zur Erhöhung der thermischen Leitfähigkeit der Wärmebrücken (13) enthalten.

2. Infrarot-Sensorvorrichtung nach Anspruch 1, wobei das Halbleitersubstrat (1) ein einkristallines Silizium-Substrat ist.

3. Infrarot-Sensorvorrichtung nach Anspruch 1 oder 2, wobei das Sensorelement (2) mittels der Aufhängeeinrichtung (10) des Sensorelements (2) in zwei Bereichen am Halbleitersubstrat (1) befestigt ist.

4. Infrarot-Sensorvorrichtung nach Anspruch 3, wobei die Aufhängeeinrichtung (10) in vertikaler Richtung im Wesentlichen symmetrisch ausgebildet ist, wobei eine elektrische Leiterbahn (4) in der Aufhängeeinrichtung (10) im Wesentlichen mittig zwischen zwei im Wesentlichen gleich dicken Schichten des Absorbermaterials (6) angeordnet ist, wobei die Leiterbahn (4) lateral von dem Absorbermaterial (6) bedeckt ist.

5. Infrarot-Sensorvorrichtung nach Anspruch 3 oder 4, wobei das Absorbermaterial (6) im Bereich der Aufhängeeinrichtung (10) des Sensorelements (2) und im Bereich der Dioden (5) des Kalibrierungselements (3) eine geringere Schichtdicke als an der übrigen Infrarot-Sensorvorrichtung (100) aufweist.

6. Infrarot-Sensorvorrichtung nach einem der Ansprüche 1 bis 5, wobei eine optische Dicke des auf dem Sensorelement (2) angeordneten Absorbermaterials (6) im Wesentlichen einem ungeradzahligen Vielfachen eines Viertels einer Wellenlänge einer zu detektierenden Strahlung (S) entspricht.

7. Infrarot-Sensorvorrichtung nach einem der Ansprüche 1 bis 6, wobei das Absorbermaterial (6) ein Oxid, insbesondere ein Siliziumoxid ist.

8. Infrarot-Sensorvorrichtung nach einem der Ansprüche 1 bis 7, wobei auf einer Oberfläche des Sensorelements (2) auf dem Absorbermaterial (6) eine Reflektorschicht (11) angeordnet ist, welche eine zu detektierende Strahlung reflektiert.

9. Infrarot-Sensorvorrichtung nach einem der Ansprüche 4 bis 8, wobei ein Material der elektrischen Leiterbahn (4) wenigstens eines aus der Gruppe: Ti, TiN, Ta, TaN und/oder eine Kombination dieser Materialien ist.

**10.** Infrarot-Sensorvorrichtung nach einem der Ansprüche 1 bis 9, wobei im Wesentlichen unterhalb des Sensorelements (2) am Boden der Kaverne (8) eine Bündelungseinrichtung (7) zum Bündeln der mittels des Sensorelements (2) zu detektierenden Strahlung (S) ausgebildet ist.

**11.** Infrarot-Sensorvorrichtung nach einem der Ansprüche 1 bis 10, wobei das Absorbermaterial (6) auf wenigstens einem Abschnitt einer Oberfläche des Sensorelements (2) und des Kalibrierungselements (3) nach oben noppenartig ausgebildet ist.

**12.** Infrarot-Sensorfeld mit mehreren Infrarot-Sensorvorrichtungen (100;200;300) nach einem der Ansprüche 1 bis 11.

**13.** Infrarot-Sensorfeld nach Anspruch 12, wobei jede Zeile und jede Spalte des Sensorfelds wenigstens ein Kalibrierungselement (3) aufweist.

**Claims**

**1.** Infrared sensor device (100; 200; 300), comprising:

- a semiconductor substrate (1);
- a multiplicity of row lines (20) and a multiplicity of column lines (30);
- at least one micromechanically formed sensor element (2), which is connected to the semiconductor substrate (1) by means of a suspension arrangement (10) of the sensor element (2), wherein the suspension arrangement (10) of the sensor element (2) comprises conductor tracks (4) for the electrical supply of the sensor element (2), said conductor tracks being electrically connected to at least one of the multiplicity of row lines (20) and/or of the multiplicity of column lines (30); and
- at least one micromechanically formed calibration element (3) for the sensor element (2), which is connected to the semiconductor substrate (1) by means of a suspension arrangement of the calibration element (3), wherein the suspension arrangement of the calibration element (3) comprises conductor tracks (4) for the electrical supply of the calibration element (3), said conductor tracks being electrically connected to at least one of the multiplicity of row lines (20) and/or of the multiplicity of column lines (30);

wherein in each case at least one diode (5) correspondingly associated with the sensor element (2) and the calibration element (3) is formed for the sensor element (2) and for the calibration element (3),
wherein an absorber material (6) is arranged at least on the diodes (5) of the sensor element (2) and of the calibration element (3);
wherein a respective cavity (8) is formed in the semiconductor substrate (1) substantially below the sensor element (2) and substantially below the calibration element (3), wherein the sensor element (2) and the calibration element (3) are separated from the rest of the semiconductor substrate (1) by means of the cavities (8);
wherein the calibration element (3) is thermally coupled to the semiconductor substrate (1) by thermal bridges (13) directly on the shortest path between a column or respectively row line region (20, 30) and a region with the at least one diode (5); and
wherein the thermal bridges (13) contain a metal structure for increasing the thermal conductivity of the thermal bridges (13).

**2.** Infrared sensor device according to Claim 1, wherein the semiconductor substrate (1) is a monocrystalline silicon substrate.

**3.** Infrared sensor device according to Claim 1 or 2, wherein the sensor element (2) is secured to the semiconductor substrate (1) in two regions by means of the suspension arrangement (10) of the sensor element (2).

**4.** Infrared sensor device according to Claim 3, wherein the suspension arrangement (10) is formed substantially symmetrically in the vertical direction, wherein an electrical conductor track (4) in the suspension arrangement (10) is arranged substantially centrally between two substantially equally thick layers of the absorber material (6), wherein the conductor track (4) is covered laterally by the absorber material (6).

**5.** Infrared sensor device according to Claim 3 or 4, wherein the absorber material (6) has a smaller layer thickness in the region of the suspension arrangement (10) of the sensor element (2) and in the region of the diodes (5) of the calibration element (3) compared with the rest of the infrared sensor device (100).

6.  Infrared sensor device according to any of Claims 1 to 5, wherein an optical thickness of the absorber material (6) arranged on the sensor element (2) substantially corresponds to an odd multiple of one quarter of a wavelength of a radiation (S) to be detected.

7.  Infrared sensor device according to any of Claims 1 to 6, wherein the absorber material (6) is an oxide, in particular a silicon oxide.

8.  Infrared sensor device according to any of Claims 1 to 7, wherein a reflector layer (11) is arranged on the absorber material (6) on a surface of the sensor element (2), said reflector layer reflecting a radiation to be detected.

9.  Infrared sensor device according to any of Claims 4 to 8, wherein a material of the electrical conductor track (4) is at least one from the group: Ti, TiN, Ta, TaN and/or a combination of these materials.

10. Infrared sensor device according to any of Claims 1 to 9, wherein a focusing arrangement (7) for focusing the radiation (S) to be detected by means of the sensor element (2) is formed substantially below the sensor element (2) at the bottom of the cavity (8).

11. Infrared sensor device according to any of Claims 1 to 10, wherein the absorber material (6) is formed in a pimpled manner towards the top on at least one section of a surface of the sensor element (2) and of the calibration element (3).

12. Infrared sensor array comprising a plurality of infrared sensor devices (100; 200; 300) according to any of Claims 1 to 11.

13. Infrared sensor array according to Claim 12, wherein each row and each column of the sensor array comprises at least one calibration element (3).


**Revendications**

1.  Dispositif capteur infrarouge (100 ; 200 ; 300) comportant :

    - un substrat semi-conducteur (1) ;
    - une multitude de conducteurs de ligne (20) et une multitude de conducteurs de colonne (30) ;
    - au moins un élément capteur (2) de conception micromécanique qui est relié au substrat semi-conducteur (1) à l'aide d'un moyen de suspension (10) de l'élément capteur (2), le moyen de suspension (10) de l'élément capteur (2) comportant des pistes conductrices (4) qui sont destinées à l'alimentation électrique de l'élément capteur (2) et qui sont reliées électriquement à l'un au moins de la multitude de conducteurs de ligne (20) et/ou de la multitude de conducteurs de colonne (30) ; et
    - au moins un élément d'étalonnage (3) de conception micromécanique qui est destiné à l'élément capteur (2) et qui est relié au substrat semi-conducteur (1) à l'aide d'un moyen de suspension de l'élément d'étalonnage (3), le moyen de suspension de l'élément d'étalonnage (3) comportant des pistes conductrices (4) qui sont destinées à l'alimentation électrique de l'élément d'étalonnage (3) et qui sont reliées électriquement à l'un au moins de la multitude de conducteurs de ligne (20) et/ou de la multitude de conducteurs de colonne (30) ;

    au moins une diode (5), qui est associée de manière appropriée à l'élément capteur (2) et à l'élément d'étalonnage (3), étant conçue pour l'élément capteur (2) et l'élément d'étalonnage (3), un matériau absorbant (6) étant disposé au moins sur les diodes (5) de l'élément capteur (2) et de l'élément d'étalonnage (3) ; une cavité (8) étant ménagée dans le substrat semi-conducteur (1) sensiblement au-dessous de l'élément capteur (2) et sensiblement au-dessous de l'élément d'étalonnage (3), l'élément capteur (2) et l'élément d'étalonnage (3) étant séparés du reste du substrat semi-conducteur (1) au moyen des cavités (8) ; l'élément d'étalonnage (3) étant couplé thermiquement au substrat semi-conducteur (1) par le biais de ponts thermiques (13) directement sur le chemin le plus court entre une zone de conducteurs de colonne ou de conducteurs de ligne (20, 30) et une zone comportant l'au moins une diode (5) ; et les ponts thermiques (13) contenant une structure métallique destinée à augmenter la conductivité thermique des ponts thermiques (13).

2.  Dispositif capteur infrarouge selon la revendication 1, le substrat semi-conducteur (1) étant un substrat en silicium monocristallin.

3. Dispositif capteur infrarouge selon la revendication 1 ou 2, l'élément capteur (2) étant fixé dans deux zones au substrat semi-conducteur (1) à l'aide du moyen de suspension (10) de l'élément capteur (2) .

4. Dispositif capteur infrarouge selon la revendication 3, le moyen de suspension (10) étant conçu de manière sensiblement symétrique dans la direction verticale, une piste conductrice électrique (4) du moyen de suspension (10) étant disposée sensiblement au centre entre deux couches sensiblement de même épaisseur du matériau absorbant (6), la piste conductrice (4) étant recouverte latéralement par le matériau absorbant (6).

5. Dispositif capteur infrarouge selon la revendication 3 ou 4, le matériau absorbant (6) ayant dans la zone du moyen de suspension (10) de l'élément capteur (2) et dans la zone des diodes (5) de l'élément d'étalonnage (3) une épaisseur de couche inférieure à celle du reste du dispositif capteur infrarouge (100).

6. Dispositif capteur infrarouge selon l'une des revendications 1 à 5, une épaisseur optique du matériau absorbant (6) disposé sur l'élément capteur (2) correspondant sensiblement à un multiple impair d'un quart de longueur d'onde d'un rayonnement (S) à détecter.

7. Dispositif capteur infrarouge selon l'une des revendications 1 à 6, le matériau absorbant (6) étant un oxyde, en particulier un oxyde de silicium.

8. Dispositif capteur infrarouge selon l'une des revendications 1 à 7, une couche réfléchissante (11) étant disposée sur une surface de l'élément capteur (2) sur le matériau absorbant (6) qui réfléchit un rayonnement à détecter.

9. Dispositif capteur infrarouge selon l'une des revendications 4 à 8, un matériau de la piste conductrice électrique (4) étant au moins un matériau du groupe : Ti, TiN, Ta, TaN et/ou une combinaison de ces matériaux.

10. Dispositif capteur infrarouge selon l'une des revendications 1 à 9, un moyen de focalisation (7) destiné à focaliser le rayonnement (S) à détecter au moyen de l'élément capteur (2) étant formé sensiblement au-dessous de l'élément capteur (2) au fond de la cavité (8).

11. Dispositif capteur infrarouge selon l'une des revendications 1 à 10, le matériau absorbant (6) étant formé à la manière d'un bouton vers le haut sur au moins une portion d'une surface de l'élément capteur (2) et de l'élément d'étalonnage (3).

12. Panneau capteur infrarouge comportant une pluralité de dispositifs capteurs infrarouges (100 ; 200 ; 300) selon l'une des revendications 1 à 11.

13. Panneau de capteur infrarouge selon la revendication 12, chaque ligne et chaque colonne du panneau capteur comportant au moins un élément d'étalonnage (3).

Fig. 1

Fig. 2

2b        2b

1

**Fig. 3a**

14       14

1

8

**Fig. 3b**

**Fig. 3c**

**Fig. 3d**

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9325877 A
- WO 2007147663 A
- US 2003057372 A1
- EP 1246251 A2
- US 2001028035 A1
- US 2002195563 A1
- WO 20050983830 A1